# EUROPEAN PATENT SPECIFICATION

(11) **EP 4 167 487 B1**
(45) Date of publication and mention of the grant of the patent: **04.11.2026**
(21) Application number: 22186206.3
(22) Date of filing: 21.07.2022
(51) Int. Cl.: H03L 7/08, H03L 7/087, G01R 25/00, H03D 13/00, H03L 7/091, H03D 3/00

(54) **LOW POWER QUADRATURE PHASE DETECTOR**
QUADRATURPHASENDETEKTOR MIT NIEDRIGER LEISTUNG
DÉTECTEUR DE PHASE EN QUADRATURE À FAIBLE PUISSANCE

(30) Priority: 13.10.2021 US 202163255030 P; 04.07.2022 US 202217857161
(43) Date of publication of application: 19.04.2023
(73) Proprietor: MediaTek Inc., Hsin-Chu 300 (TW)
(72) Inventor: LEE, Fong-Wen, 30078 Hsinchu City (TW); WANG, Wen-Chieh, 30078 Hsinchu City (TW); LIN, Yu-Hsin, 30078 Hsinchu City (TW)
(74) Representative: Haseltine Lake Kempner LLP

(56) References cited:
- US-A1- 2017 222 796
- US-A1- 2020 186 323
- ANONYMOUS: "Pass transistor logic - Wikipedia", 29 March 2021 (2021-03-29), pages 1 - 4, XP093009148, Retrieved from the Internet <URL:https://en.wikipedia.org/w/index.php?title=Pass_transistor_logic&oldid=1014867294> [retrieved on 20221217]
- FAIROOZ SHAIK ET AL: "Revisiting the Utility of Transmission Gate and Passtransistor Logic Styles in CMOS VLSI Design", 2021 3RD INTERNATIONAL CONFERENCE ON SIGNAL PROCESSING AND COMMUNICATION (ICPSC), IEEE, 13 May 2021 (2021-05-13), pages 276 - 280, XP033924761, [retrieved on 20210609], DOI: 10.1109/ICSPC51351.2021.9451645

## Description

This application claims the benefit of U.S. Provisional Application No. 63/255, 030, filed on October 13th, 2021.

### Background

A quadrature phase detector is usually provided to detect a phase difference between an in-phase clock signal and a quadrature clock signal, and a detection result of the quadrature phase detector may be used by a clock signal generator or a delay element to adjust the phase of the in-phase clock signal or the quadrature clock signal. The conventional quadrature phase detector is usually implemented by using active devices such as XOR gates, however, using XOR gates may increase the power consumption. In addition, if the quadrature phase detector is designed to detect four clock signals whose phases are 0 degree, 90 degrees, 180 degrees and 270 degrees, four sets of circuits are designed to detect the phase difference between clock signals with 0 degree and 90 degrees, the phase difference between clock signals with 90 degrees and 180 degrees, the phase difference between clock signals with 180 degrees and 270 degrees, and the phase difference between clock signals with 270 degrees and 0 degree. However, there may be mismatches between the four sets of circuits due to the semiconductor process, causing phase detection mismatches or phase detection errors. US 2020/186323 A1 describes an apparatus for providing fast-settling quadrature detection and correction.
US 2017/222796 A1 describes systems and methods for detecting and correcting phased clock error (PCE) in phased clock circuits.

### Summary

It is therefore an objective of the present invention to provide a quadrature phase detector in which most of the components are implemented by using passive components, to lower power consumption and improve the phase detection mismatches.

According to one embodiment of the present invention, there is a quadrature phase detector such as defined in claim 1. Advantageous modifications are defined in the dependent claims.

These and other objectives of the present invention will no doubt become obvious to those of ordinary skill in the art after reading the following detailed description of the preferred embodiment that is illustrated in the various figures and drawings.

### Brief Description of the Drawings

FIG. 1 is a diagram illustrating a circuitry according to one embodiment of the present invention.
FIG. 2 is a diagram illustrating the first detection circuit according to one embodiment of the present invention.
FIG. 3 is a diagram illustrating the second detection circuit according to one embodiment of the present invention.
FIG. 4 is a diagram illustrating the third detection circuit according to one embodiment of the present invention.
FIG. 5 is a diagram illustrating the fourth detection circuit according to one embodiment of the present invention.
FIG. 6 is a diagram illustrating the first detection circuit according to one embodiment of the present invention.
FIG. 7 is a diagram illustrating the second detection circuit according to one embodiment of the present invention.
FIG. 8 is a diagram illustrating the third detection circuit according to one embodiment of the present invention.
FIG. 9 is a diagram illustrating the fourth detection circuit according to one embodiment of the present invention.

### Detailed Description

Certain terms are used throughout the following description and claims to refer to particular system components. As one skilled in the art will appreciate, manufacturers may refer to a component by different names. This document does not intend to distinguish between components that differ in name but not function. In the following discussion and in the claims, the terms "including" and "comprising" are used in an open-ended fashion, and thus should be interpreted to mean "including, but not limited to ...". The terms "couple" and "couples" are intended to mean either an indirect or a direct electrical connection. Thus, if a first device couples to a second device, that connection may be through a direct electrical connection, or through an indirect electrical connection via other devices and connections.

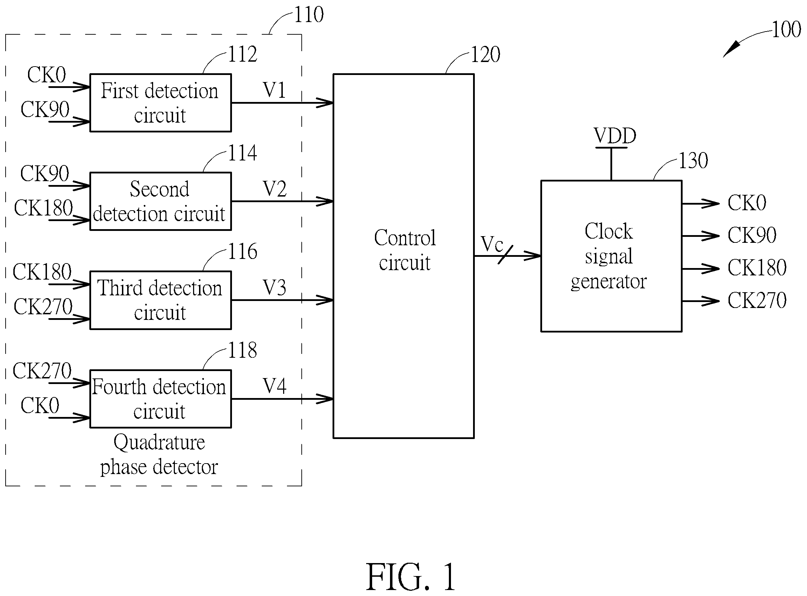

FIG. 1 is a diagram illustrating a circuitry 100 according to one embodiment of the present invention. As shown in FIG. 1, the circuitry 100 comprises a quadrature phase detector 110, a control circuit 120 and a clock signal generator 130, wherein the quadrature phase detector 110 comprises a first detection circuit 112, a second detection circuit 114, a third detection circuit 116 and a fourth detection circuit 118. In this embodiment, the circuitry 100 is configured to generate four clock signals CK0, CK90, CK180 and CK270 with ideal phases of 0 degree, 90 degrees, 180 degrees and 270 degrees, respectively.

In the operation of the circuitry 100, the quadrature phase detector 110 is configured to detect phase differences between any two adjacent clock signals to generate detection results. Specifically, the first detection circuit 112 is configured to detect a phase difference between the clock signals CK0 and CK90 to generate a first detection result V1, the second detection circuit 114 is configured to detect a phase difference between the clock signals CK90 and CK180 to generate a second detection result V2, the third detection circuit 116 is configured to detect a phase difference between the clock signals CK180 and CK270 to generate a third detection result V3, and the fourth detection circuit 118 is configured to detect a phase difference between the clock signals CK270 and CK0 to generate a fourth detection result V4. Then, the control circuit 120 refers to the first detection result V1, the second detection result V2, the third detection result V3 and the fourth detection result V4 to determine if any one of the clock signals CK0 CK90, CK180 and CK270 needs to adjust the phase, and at least one control signal Vc is generated accordingly. Specifically, the control circuit 120 can refer to the first detection result V1 to determine if the phase difference between the clock signals CK0 and CK90 is not equal to 90 degrees, and to generate the control signal Vc to the clock signal generator 130 to adjust the phase of the clock signal CK90. The control circuit 120 can refer to the second detection result V2 to determine if the phase difference between the clock signals CK90 and CK180 is not equal to 90 degrees, and to generate the control signal Vc to the clock signal generator 130 to adjust the phase of the clock signal CK180. The control circuit 120 can refer to the third detection result V3 to determine if the phase difference between the clock signals CK180 and CK270 is not equal to 90 degrees, and to generate the control signal Vc to the clock signal generator 130 to adjust the phase of the clock signal CK270. The control circuit 120 can refer to the fourth detection result V4 to determine if the phase difference between the clock signals CK270 and CK0 is not equal to 90 degrees, and to generate the control signal Vc to the clock signal generator 130 to adjust the phase of the clock signal CK0.

In this embodiment, at least a portion of the first detection circuit 112, the second detection circuit 114 and the third detection circuit 116 and the fourth detection circuit 118 are designed so that most of the components are implemented by using passive components, to lower power consumption and improve the phase detection mismatches.

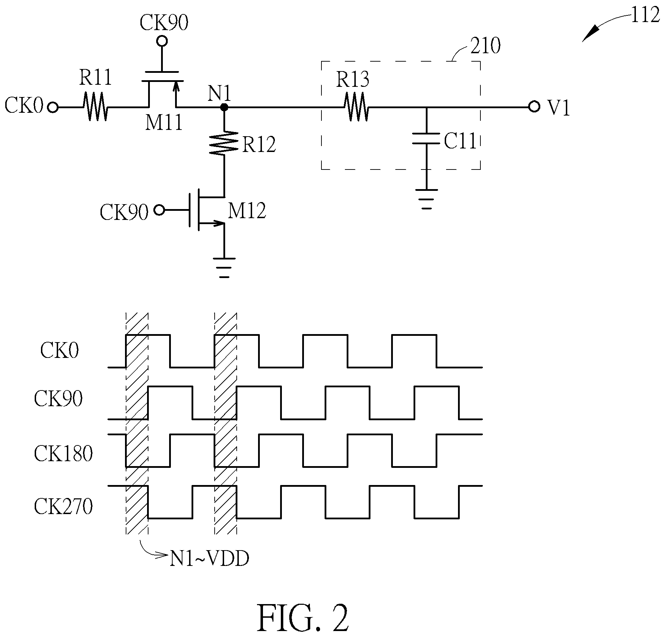

FIG. 2 is a diagram illustrating the first detection circuit 112 according to one embodiment of the present invention. As shown in FIG. 2, the first detection circuit 112 comprises transistors M11, M12, resistors R11, R12 and a low-pass filter 210, wherein the low-pass filter 210 comprises a resistor R13 and a capacitor C11. In this embodiment, the transistor M11 is a P-type transistor while the transistor M12 is an N-type transistor, a gate electrode of the transistor M11 is coupled to the clock signal CK90, a first electrode of the M11 is coupled to a first electrode of the transistor M12 via the node N1 and the resistor R12, a second electrode of the transistor M11 is coupled to the clock signal CK0 via the resistor R11, and a second electrode of the transistor M12 is coupled to a ground voltage.

In another embodiment, the transistor M11 can be replaced by a switch with any different type, and this switch is controlled by the clock signal CK90 to selectively connect the clock signal CK0 to the node N1. In addition, the transistor M12 can be replaced by a switch with any different type, and this switch is controlled by the clock signal CK90 to selectively connect the node N1 to the ground voltage.

In the operation of the first detection circuit 112, when the clock signal CK90 has a low voltage (e.g. ground voltage or 0V) and the clock signal CK0 has a high voltage such as a supply voltage VDD of the clock signal generator 130, the node N1 will have the high voltage (e.g. VDD); when both the clock signals CK90 and CK0 have the low voltage, the node N1 will have the low voltage; and when the clock signal CK90 has the high voltage, the node N1 will always have the low voltage because the transistor M12 with larger driving ability discharges the node N1. Therefore, because the node N1 has the high voltage only during quarter-cycle of the clock signal CK0/CK90, the first detection result V1 generated by filtering the voltage of the node N1 should be equal to (1/4) *VDD if the phase difference between the clock signals CK0 and CK90 is exactly equal to 90 degrees.

In one embodiment, if the first detection result V1 is lower than (1/4)*VDD, it means that the phase difference between the clock signals CK0 and CK90 is less than 90 degrees, and the control circuit 120 may generate the control signal Vc to control the clock signal generator 130 to delay the phase of the clock signal CK90. Similarly, if the first detection result V1 is greater than (1/4)*VDD, it means that the phase difference between the clock signals CK0 and CK90 is greater than 90 degrees, and the control circuit 120 may generate the control signal Vc to control the clock signal generator 130 to advance the phase of the clock signal CK90.

In the embodiment shown in FIG. 2, the first detection circuit 112 is configured to detect the phase difference based on rising edges of the clock signals CK0 and CK90. In another embodiment, the transistor M11 may be implemented by an N-type transistor while the transistor M12 is implemented by the P-type transistor, for detecting the phase difference based on falling edges of the clock signals CK0 and CK90.

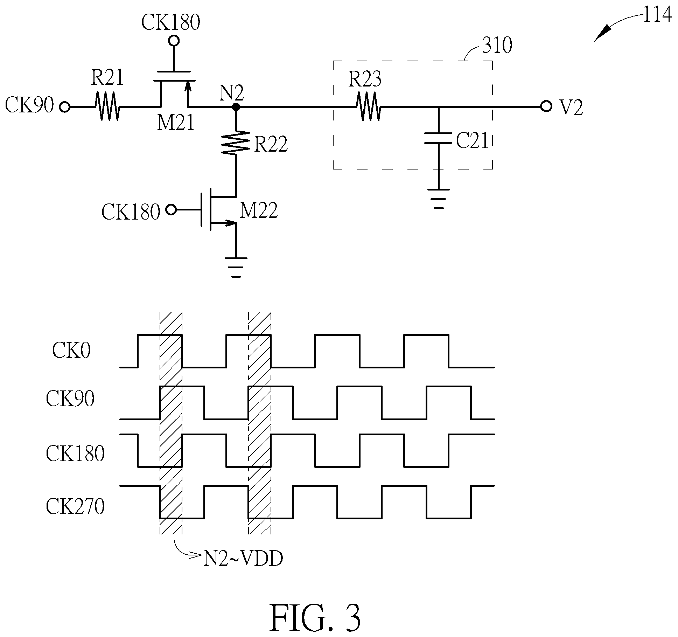

FIG. 3 is a diagram illustrating the second detection circuit 114 according to one embodiment of the present invention. As shown in FIG. 3, the second detection circuit 114 comprises transistors M21, M22, resistors R21, R22 and a low-pass filter 310, wherein the low-pass filter 310 comprises a resistor R23 and a capacitor C21. In this embodiment, the transistor M21 is a P-type transistor while the transistor M22 is an N-type transistor, a gate electrode of the transistor M21 is coupled to the clock signal CK180, a first electrode of the M21 is coupled to a first electrode of the transistor M22 via the node N2 and the resistor R22, a second electrode of the transistor M21 is coupled to the clock signal CK90 via the resistor R21, and a second electrode of the transistor M22 is coupled to the ground voltage.

In another embodiment, the transistor M21 can be replaced by a switch with any different type, and this switch is controlled by the clock signal CK180 to selectively connect the clock signal CK90 to the node N2. In addition, the transistor M22 can be replaced by a switch with any different type, and this switch is controlled by the clock signal CK180 to selectively connect the node N2 to the ground voltage.

In the operation of the second detection circuit 114, when the clock signal CK180 has a low voltage (e.g. ground voltage or 0V) and the clock signal CK90 has a high voltage such as a supply voltage VDD of the clock signal generator 130, the node N2 will have the high voltage (e.g. VDD); when both the clock signals CK180 and CK90 have the low voltage, the node N2 will have the low voltage; and when the clock signal CK180 has the high voltage, the node N2 will always have the low voltage because the transistor M22 with larger driving ability discharges the node N2. Therefore, because the node N2 has the high voltage only during quarter-cycle of the clock signal CK90/CK180, the second detection result V2 generated by filtering the voltage of the node N2 should be equal to (1/4) *VDD if the phase difference between the clock signals CK90 and CK180 is exactly equal to 90 degrees.

In one embodiment, if the second detection result V2 is lower than (1/4)*VDD, it means that the phase difference between the clock signals CK90 and CK180 is less than 90 degrees, and the control circuit 120 may generate the control signal Vc to control the clock signal generator 130 to delay the phase of the clock signal CK180. Similarly, if the second detection result V2 is greater than (1/4)*VDD, it means that the phase difference between the clock signals CK90 and CK180 is greater than 90 degrees, and the control circuit 120 may generate the control signal Vc to control the clock signal generator 130 to advance the phase of the clock signal CK180.

In the embodiment shown in FIG. 3, the second detection circuit 114 is configured to detect the phase difference based on rising edges of the clock signals CK90 and CK180. In another embodiment, the transistor M21 may be implemented by the N-type transistor while the transistor M22 is implemented by the P-type transistor, for detecting the phase difference based on falling edges of the clock signals CK90 and CK180.

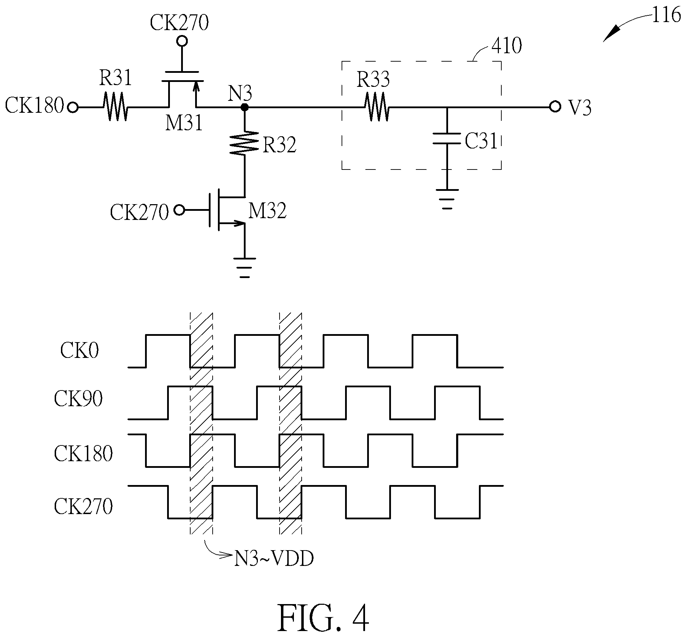

FIG. 4 is a diagram illustrating the third detection circuit 116 according to one embodiment of the present invention. As shown in FIG. 4, the third detection circuit 116 comprises transistors M31, M32, resistors R31, R32 and a low-pass filter 410, wherein the low-pass filter 410 comprises a resistor R33 and a capacitor C31. In this embodiment, the transistor M31 is the P-type transistor while the transistor M32 is the N-type transistor, a gate electrode of the transistor M31 is coupled to the clock signal CK270, a first electrode of the M31 is coupled to a first electrode of the transistor M32 via the node N3 and the resistor R32, a second electrode of the transistor M31 is coupled to the clock signal CK180 via the resistor R31, and a second electrode of the transistor M32 is coupled to the ground voltage.

In another embodiment, the transistor M31 can be replaced by a switch with any different type, and this switch is controlled by the clock signal CK270 to selectively connect the clock signal CK180 to the node N3. In addition, the transistor M32 can be replaced by a switch with any different type, and this switch is controlled by the clock signal CK270 to selectively connect the node N3 to the ground voltage.

In the operation of the third detection circuit 116, when the clock signal CK270 has a low voltage (e.g. ground voltage or 0V) and the clock signal CK180 has a high voltage such as a supply voltage VDD of the clock signal generator 130, the node N3 will have the high voltage (e.g. VDD); when both the clock signals CK270 and CK180 have the low voltage, the node N3 will have the low voltage; and when the clock signal CK270 has the high voltage, the node N3 will always have the low voltage because the transistor M32 with larger driving ability discharges the node N3. Therefore, because the node N3 has the high voltage only during quarter-cycle of the clock signal CK180/CK270, the third detection result V3 generated by filtering the voltage of the node N3 should be equal to (1/4) *VDD if the phase difference between the clock signals CK180 and CK270 is exactly equal to 90 degrees.

In one embodiment, if the third detection result V3 is lower than (1/4)*VDD, it means that the phase difference between the clock signals CK180 and CK270 is less than 90 degrees, and the control circuit 120 may generate the control signal Vc to control the clock signal generator 130 to delay the phase of the clock signal CK270. Similarly, if the third detection result V3 is greater than (1/4)*VDD, it means that the phase difference between the clock signals CK180 and CK270 is greater than 90 degrees, and the control circuit 120 may generate the control signal Vc to control the clock signal generator 130 to advance the phase of the clock signal CK270.

In the embodiment shown in FIG. 4, the third detection circuit 116 is configured to detect the phase difference based on rising edges of the clock signals CK180 and CK270. In another embodiment, the transistor M31 may be implemented by the N-type transistor while the transistor M32 is implemented by the P-type transistor, for detecting the phase difference based on falling edges of the clock signals CK180 and CK270.

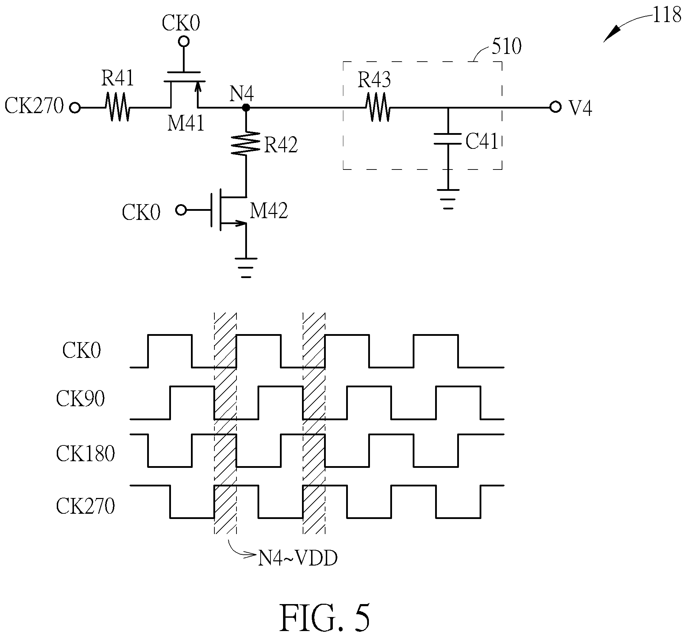

FIG. 5 is a diagram illustrating the fourth detection circuit 118 according to one embodiment of the present invention. As shown in FIG. 5, the fourth detection circuit 118 comprises transistors M41, M42, resistors R41, R42 and a low-pass filter 510, wherein the low-pass filter 510 comprises a resistor R43 and a capacitor C41. In this embodiment, the transistor M41 is the P-type transistor while the transistor M42 is the N-type transistor, a gate electrode of the transistor M41 is coupled to the clock signal CK0, a first electrode of the M41 is coupled to a first electrode of the transistor M42 via the node N4 and the resistor R42, a second electrode of the transistor M41 is coupled to the clock signal CK270 via the resistor R41, and a second electrode of the transistor M42 is coupled to the ground voltage.

In another embodiment, the transistor M41 can be replaced by a switch with any different type, and this switch is controlled by the clock signal CK0 to selectively connect the clock signal CK270 to the node N4. In addition, the transistor M42 can be replaced by a switch with any different type, and this switch is controlled by the clock signal CK0 to selectively connect the node N4 to the ground voltage.

In the operation of the fourth detection circuit 118, when the clock signal CK0 has a low voltage (e.g. ground voltage or 0V) and the clock signal CK270 has a high voltage such as a supply voltage VDD of the clock signal generator 130, the node N4 will have the high voltage (e.g. VDD) ; when both the clock signals CK0 and CK270 have the low voltage, the node N4 will have the low voltage; and when the clock signal CK0 has the high voltage, the node N4 will always have the low voltage because the transistor M42 with larger driving ability discharges the node N4. Therefore, because the node N4 has the high voltage only during quarter-cycle of the clock signal CK270/CK0, the fourth detection result V4 generated by filtering the voltage of the node N4 should be equal to (1/4) *VDD if the phase difference between the clock signals CK270 and CK0 is exactly equal to 90 degrees.

In one embodiment, if the fourth detection result V4 is lower than (1/4)*VDD, it means that the phase difference between the clock signals CK270 and CK0 is less than 90 degrees, and the control circuit 120 may generate the control signal Vc to control the clock signal generator 130 to delay the phase of the clock signal CK0. Similarly, if the fourth detection result V4 is greater than (1/4)*VDD, it means that the phase difference between the clock signals CK270 and CK0 is greater than 90 degrees, and the control circuit 120 may generate the control signal Vc to control the clock signal generator 130 to advance the phase of the clock signal CK0.

In the embodiment shown in FIG. 5, the fourth detection circuit 118 is configured to detect the phase difference based on rising edges of the clock signals CK270 and CK0. In another embodiment, the transistor M41 may be implemented by the N-type transistor while the transistor M42 is implemented by the P-type transistor, for detecting the phase difference based on falling edges of the clock signals CK270 and CK180.

In the embodiment shown in FIGs. 2-5, because the components within the first detection circuit 112, the second detection circuit 114, the third detection circuit 116 and the fourth detection circuit 118 do not need to be powered by the supply voltage VDD, power consumption of the circuitry 100 can be greatly reduced. In addition, because the passive devices such as resistors R11, R21, R31 and R41 have small errors in process, phase detection mismatches of the first detection circuit 112, the second detection circuit 114, the third detection circuit 116 and the fourth detection circuit 118 can be improved.

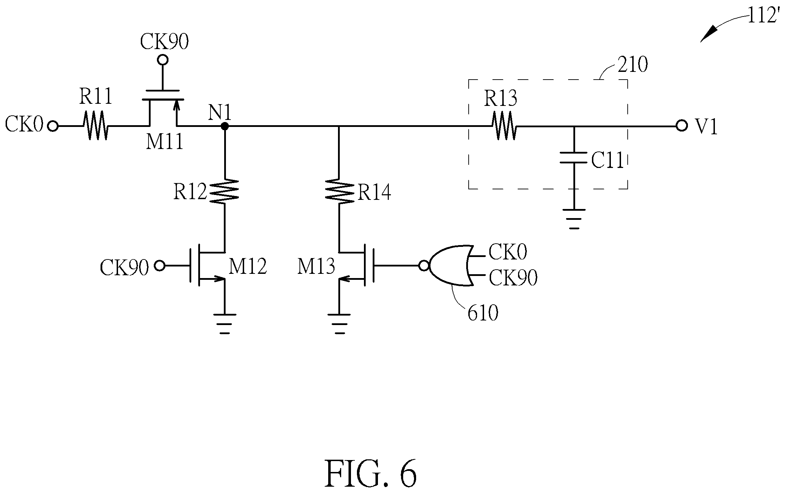

In the first detection circuit 112 shown in FIG. 2, the node N1 may not exactly have the ground voltage or 0V when both the clock signals CK0 and CK90 have the low voltage due to large turn-on resistance of the transistor M11, causing the first detection result V1 has error. To solve this problem, the first detection circuit 112 can be modified to have a compensation circuit to control the node N1 to have the ground voltage or 0V when both the clock signals CK0 and CK90 have the low voltage. Referring to FIG. 6, the first detection circuit 112' further comprises the compensation circuit including a transistor M13, a resistor R14 and a NOR gate 610, wherein the NOR gate 610 receives the clock signals CK0 and CK90. In the operation of the compensation circuit shown in FIG. 6, when both the clock signals CK0 and CK90 have the low voltage, an output signal of the NOR gate 610 will enable the transistor M13 to discharge the node N1, so that the node N1 can have the ground voltage. Therefore, the first detection result V1 can reflect the phase difference of the clock signals CK0 and CK90 more accurately.

It is noted that the compensation circuit shown in FIG. 6 is for illustrative, not a limitation of the present invention. As long as the compensation circuit can discharge the node N1 when the transistor M11 is enabled and the clock signal CK0 has the low voltage (i.e., both the clock signals CK0 and CK90 have the low voltage), the compensation circuit can have any other suitable design. In one embodiment, the compensation circuit discharges the node N1 only when the transistor M11 is enabled and the clock signal CK0 has the low voltage.

In addition, for the case that the transistor M11 is implemented by the N-type transistor, the compensation circuit is designed so that the node N1 is discharged when the clock signal CK0 has the low voltage and the clock signal CK90 have the high voltage.

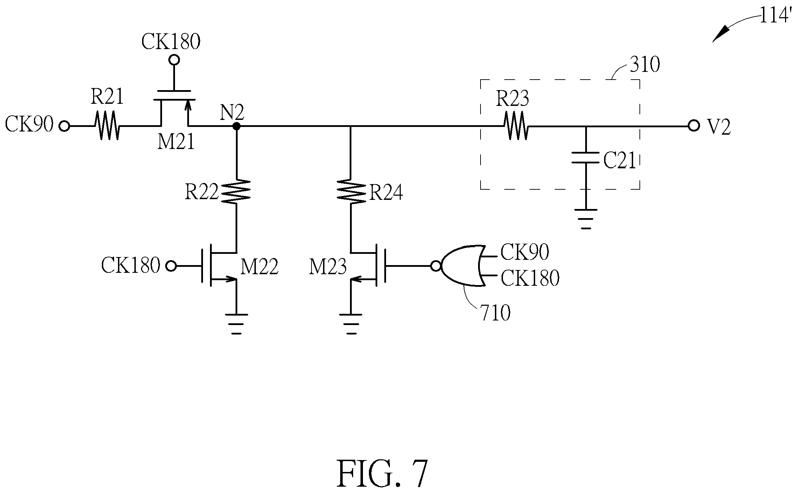

In the second detection circuit 114 shown in FIG. 3, the node N2 may not exactly have the ground voltage or 0V when both the clock signals CK90 and CK180 have the low voltage due to large turn-on resistance of the transistor M21, causing the second detection result V2 has error. To solve this problem, the second detection circuit 114 can be modified to have a compensation circuit to control the node N2 to have the ground voltage or 0V when both the clock signals CK90 and CK180 have the low voltage. Referring to FIG. 7, the second detection circuit 114' further comprises the compensation circuit including a transistor M23, a resistor R24 and a NOR gate 710, wherein the NOR gate 710 receives the clock signals CK90 and CK180. In the operation of the compensation circuit shown in FIG. 7, when both the clock signals CK90 and CK180 have the low voltage, an output signal of the NOR gate 710 will enable the transistor M23 to discharge the node N2, so that the node N2 can have the ground voltage. Therefore, the second detection result V2 can reflect the phase difference of the clock signals CK90 and CK180 more accurately.

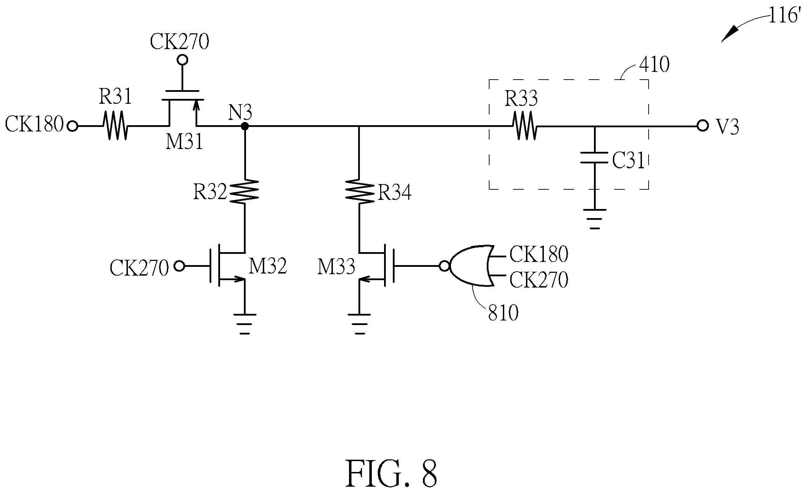

In the third detection circuit 116 shown in FIG. 4, the node N3 may not exactly have the ground voltage or 0V when both the clock signals CK180 and CK270 have the low voltage due to large turn-on resistance of the transistor M31, causing the second detection result V3 has error. To solve this problem, the third detection circuit 116 can be modified to have a compensation circuit to control the node N3 to have the ground voltage or 0V when both the clock signals CK180 and CK270 have the low voltage. Referring to FIG. 8, the third detection circuit 116' further comprises the compensation circuit including a transistor M33, a resistor R34 and a NOR gate 810, wherein the NOR gate 810 receives the clock signals CK180 and CK270. In the operation of the compensation circuit shown in FIG. 8, when both the clock signals CK180 and CK270 have the low voltage, an output signal of the NOR gate 810 will enable the transistor M33 to discharge the node N3, so that the node N3 can have the ground voltage. Therefore, the second detection result V3 can reflect the phase difference of the clock signals CK180 and CK270 more accurately.

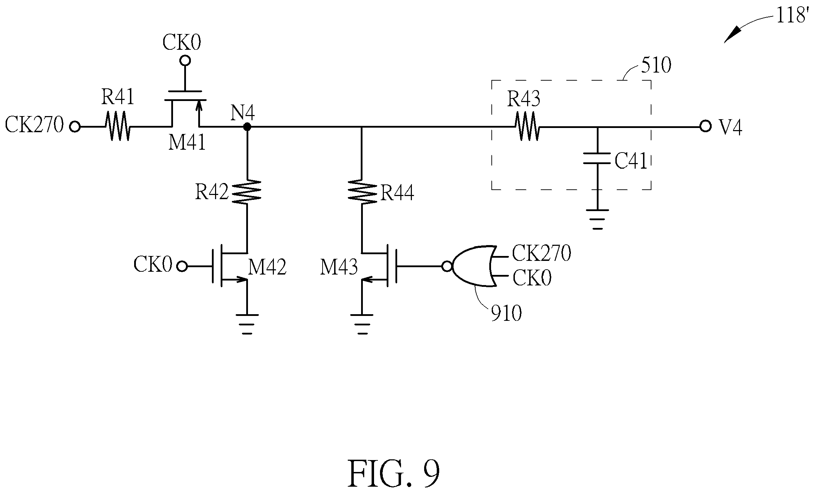

In the fourth detection circuit 118 shown in FIG. 5, the node N4 may not exactly have the ground voltage or 0V when both the clock signals CK270 and CK0 have the low voltage due to large turn-on resistance of the transistor M41, causing the second detection result V4 has error. To solve this problem, the third detection circuit 118 can be modified to have a compensation circuit to control the node N4 to have the ground voltage or 0V when both the clock signals CK270 and CK0 have the low voltage. Referring to FIG. 9, the fourth detection circuit 118' further comprises the compensation circuit including a transistor M43, a resistor R44 and a NOR gate 910, wherein the NOR gate 910 receives the clock signals CK270 and CK0. In the operation of the compensation circuit shown in FIG. 9, when both the clock signals CK270 and CK0 have the low voltage, an output signal of the NOR gate 910 will enable the transistor M43 to discharge the node N4, so that the node N4 can have the ground voltage. Therefore, the second detection result V4 can reflect the phase difference of the clock signals CK270 and CK0 more accurately.

In the embodiment shown in FIGs. 6-9, because most of the components within the first detection circuit 112' , the second detection circuit 114', the third detection circuit 116' and the fourth detection circuit 118' do not need to be powered by the supply voltage VDD, power consumption of the circuitry 100 can be greatly reduced. In addition, because the passive devices such as resistors R11, R21, R31 and R41 have small errors in process, phase detection mismatches of the first detection circuit 112', the second detection circuit 114', the third detection circuit 116' and the fourth detection circuit 118' can be improved.

It is noted that quantity of the detection circuits within the quadrature phase detector 110 is for illustrative, not a limitation of the present invention. In other embodiments, the quadrature phase detector 110 may have the first detection circuit 112 only, or the quadrature phase detector 110 may have the first detection circuit 112 and the second detection circuit 114 only, or the quadrature phase detector 110 may have the first detection circuit 112, the second detection circuit 114 and the third detection circuit 116 only. These alternative designs should fall within the scope of the present invention.

Those skilled in the art will readily observe that numerous modifications and alterations of the device and method may be made while retaining the teachings of the invention. Accordingly, the above disclosure should be construed as limited only by the scope of the appended claims.

## Claims

1. A quadrature phase detector (110), comprising:
a first detection circuit (112, 112') configured to detect a phase difference between a first clock signal and a second clock signal, comprising:
a first switch, wherein the first switch is controlled by the second clock signal (CK90) to selectively couple the first clock signal (CK0) to a first node;
a second switch, wherein the second switch is controlled by the second clock signal (CK90) to selectively coupled the first node to a ground voltage; and
a first filter, configured to filter voltages at the first node to generate a first detection result;
wherein the first switch is a first transistor comprising a gate electrode, a first electrode and a second electrode, wherein the first transistor receives the first clock signal (CK0) at the second electrode, and receives the second clock signal (CK90) at the gate electrode; and the second switch is a second transistor comprising a gate electrode, a first electrode and a second electrode, wherein the first electrode of the second transistor is coupled to the first electrode of the first transistor at the first node, the second transistor receives the second clock signal (CK90) at the gate electrode, and the second electrode of the second transistor is coupled to the ground voltage; wherein the first transistor is a P-type transistor (M11), and the second transistor is an N-type transistor (M12); or
wherein the first transistor is an N-type transistor, and the second transistor is a P-type transistor.

2. The quadrature phase detector (110) of claim 1, wherein the first detection circuit (112, 112') further comprises:
a compensation circuit, configured to selectively provide a discharging path for discharging the first node.

3. The quadrature phase detector (110) of claim 2, wherein the compensation circuit is configured to provide the discharging path to discharge the first node when the first switch is enabled and the first clock signal (CK0) has a low voltage level.

4. The quadrature phase detector (110) of claim 1, wherein ideally a phase difference between the first clock signal (CK0) and the second clock signal (CK90) is equal to 90 degrees, and the quadrature phase detector (110) further comprises:
a second detection circuit (114, 114'), comprising:
a third switch, wherein the third switch is controlled by a third clock signal (CK180) to selectively couple the second clock signal (CK90) to a second node;
a fourth switch, wherein the fourth switch is controlled by the third clock signal to selectively coupled the second node to the ground voltage; and
a second filter, configured to filter voltages at the second node to generate a second detection result.

5. The quadrature phase detector (110) of claim 4, wherein ideally a phase difference between the second clock signal (CK90) and the third clock signal (CK180) is equal to 90 degrees, and the quadrature phase detector (110) further comprises:
a third detection circuit (116, 116'), comprising:
a fifth switch, wherein the fifth switch is controlled by a fourth clock signal (CK270) to selectively couple the third clock signal (CK180) to a third node;
a sixth switch, wherein the sixth switch is controlled by the fourth clock signal (CK270) to selectively coupled the third node to the ground voltage; and
a third filter, configured to filter voltages at the third node to generate a third detection result.

6. The quadrature phase detector (110) of claim 1, wherein the quadrature phase detector (110) is within a circuitry (100), and the circuitry comprises:
a clock signal generator (130), configured to generate a first clock signal (CK0) and a second clock signal(CK90),
a control circuit (120), coupled to the first detection circuit (112, 112'), configured to generate a control signal to adjust a phase of the first clock signal (CK0) or the second clock signal (CK90) according to the first detection result.

## Patentansprüche

1. Quadraturphasendetektor (110), umfassend:
eine erste Detektionsschaltung (112, 112'), die ausgelegt ist, eine Phasendifferenz zwischen einem ersten Taktsignal und einem zweiten Taktsignal zu detektieren, umfassend:
einen ersten Schalter, wobei der erste Schalter durch das zweite Taktsignal (CK90) gesteuert ist, um das erste Taktsignal (CK0) selektiv mit einem ersten Knoten zu koppeln;
einen zweiten Schalter, wobei der zweite Schalter durch das zweite Taktsignal (CK90) gesteuert ist, um den ersten Knoten selektiv mit einer Massespannung zu koppeln; und
einen ersten Filter, ausgelegt zum Filtern von Spannungen an dem ersten Knoten, um ein erstes Detektionsergebnis zu erzeugen;
wobei der erste Schalter ein erster Transistor ist, umfassend eine Gateelektrode, eine erste Elektrode und eine zweite Elektrode, wobei der erste Transistor das erste Taktsignal (CK0) an der zweiten Elektrode empfängt und das zweite Taktsignal (CK90) an der Gateelektrode empfängt; und der zweite Schalter ein zweiter Transistor ist, umfassend eine Gateelektrode, eine erste Elektrode und eine zweite Elektrode, wobei die erste Elektrode des zweiten Transistors mit der ersten Elektrode des ersten Transistors an dem ersten Knoten gekoppelt ist, der zweite Transistor das zweite Taktsignal (CK90) an der Gateelektrode empfängt und die zweite Elektrode des zweiten Transistors mit der Massespannung gekoppelt ist; wobei der erste Transistor ein P-Typ-Transistor (M11) ist und der zweite Transistor ein N-Typ-Transistor (M12) ist; oder
wobei der erste Transistor ein N-Typ-Transistor ist und der zweite Transistor ein P-Typ-Transistor ist.

2. Quadraturphasendetektor (110) nach Anspruch 1, wobei die erste Detektionsschaltung (112, 112') ferner umfasst:
eine Kompensationsschaltung, ausgelegt zum selektiven Bereitstellen eines Entladepfads zum Entladen des ersten Knotens.

3. Quadraturphasendetektor (110) nach Anspruch 2, wobei die Kompensationsschaltung ausgelegt ist, den Entladepfad zum Entladen des ersten Knotens bereitzustellen, wenn der erste Schalter aktiviert ist und das erste Taktsignal (CK0) einen niedrigen Spannungspegel aufweist.

4. Quadraturphasendetektor (110) nach Anspruch 1, wobei idealerweise eine Phasendifferenz zwischen dem ersten Taktsignal (CK0) und dem zweiten Taktsignal (CK90) gleich 90 Grad ist und der Quadraturphasendetektor (110) ferner umfasst:
eine zweite Detektionsschaltung (114, 114'), umfassend:
einen dritten Schalter, wobei der dritte Schalter durch ein drittes Taktsignal (CK180) gesteuert ist, um das zweite Taktsignal (CK90) selektiv mit einem zweiten Knoten zu koppeln;
einen vierten Schalter, wobei der vierte Schalter durch das dritte Taktsignal gesteuert ist, um den zweiten Knoten selektiv mit der Massespannung zu koppeln; und
einen zweiten Filter, ausgelegt zum Filtern von Spannungen an dem zweiten Knoten, um ein zweites Detektionsergebnis zu erzeugen.

5. Quadraturphasendetektor (110) nach Anspruch 4, wobei idealerweise eine Phasendifferenz zwischen dem zweiten Taktsignal (CK90) und dem dritten Taktsignal (CK180) gleich 90 Grad ist und der Quadraturphasendetektor (110) ferner umfasst:
eine dritte Detektionsschaltung (116, 116'), umfassend:
einen fünften Schalter, wobei der fünfte Schalter durch ein viertes Taktsignal (CK270) gesteuert ist, um das dritte Taktsignal (CK180) selektiv mit einem dritten Knoten zu koppeln;
einen sechsten Schalter, wobei der sechste Schalter durch das vierte Taktsignal (CK270) gesteuert ist, um den dritten Knoten selektiv mit der Massespannung zu koppeln; und
einen dritten Filter, ausgelegt zum Filtern von Spannungen an dem dritten Knoten, um ein drittes Detektionsergebnis zu erzeugen.

6. Quadraturphasendetektor (110) nach Anspruch 1, wobei der Quadraturphasendetektor (110) innerhalb eines Schaltkreises (100) ist und der Schaltkreis umfasst:
einen Taktsignalgenerator (130), ausgelegt zum Erzeugen eines ersten Taktsignals (CK0) und eines zweiten Taktsignals (CK90), eine Steuerschaltung (120), gekoppelt mit der ersten Detektionsschaltung (112, 112'), ausgelegt zum Erzeugen eines Steuersignals zum Einstellen einer Phase des ersten Taktsignals (CK0) oder des zweiten Taktsignals (CK90) gemäß dem ersten Detektionsergebnis.

## Revendications

1. Détecteur de phase en quadrature (110), comprenant :
un premier circuit de détection (112, 112') configuré pour détecter une différence de phase entre un premier signal d'horloge et un deuxième signal d'horloge, comprenant :
un premier commutateur, dans lequel le premier commutateur est commandé par le deuxième signal d'horloge (CK90) pour coupler sélectivement le premier signal d'horloge (CK0) à un premier nœud ;
un deuxième commutateur, dans lequel le deuxième commutateur est commandé par le deuxième signal d'horloge (CK90) pour coupler sélectivement le premier nœud à une tension de masse ; et
un premier filtre, configuré pour filtrer les tensions au niveau du premier nœud afin de générer un premier résultat de détection ;
dans lequel le premier commutateur est un premier transistor comprenant une électrode de grille, une première électrode et une seconde électrode, dans lequel le premier transistor reçoit le premier signal d'horloge (CK0) au niveau de la seconde électrode et reçoit le deuxième signal d'horloge (CK90) au niveau de l'électrode de grille ; et le deuxième commutateur est un second transistor comprenant une électrode de grille, une première électrode et une seconde électrode, dans lequel la première électrode du second transistor est couplée à la première électrode du premier transistor au niveau du premier nœud, le second transistor reçoit le deuxième signal d'horloge (CK90) au niveau de l'électrode de grille et la seconde électrode du second transistor est couplée à la tension de masse ; dans lequel le premier transistor est un transistor de type P (M11) et le second transistor un transistor de type N (M12) ; ou
dans lequel le premier transistor est un transistor de type N et le second transistor est un transistor de type P.

2. Détecteur de phase en quadrature (110) selon la revendication 1, dans lequel le premier circuit de détection (112, 112') comprend en outre :
un circuit de compensation, configuré pour fournir sélectivement un chemin de décharge pour décharger le premier nœud.

3. Détecteur de phase en quadrature (110) selon la revendication 2, dans lequel le circuit de compensation est configuré pour fournir le chemin de décharge afin de décharger le premier nœud lorsque le premier commutateur est activé et que le premier signal d'horloge (CK0) a un niveau de tension bas.

4. Détecteur de phase en quadrature (110) selon la revendication 1, dans lequel idéalement la différence de phase entre le premier signal d'horloge (CK0) et le deuxième signal d'horloge (CK90) est égale à 90 degrés, et le détecteur de phase en quadrature (110) comprend en outre :
un deuxième circuit de détection (114, 114'), comprenant :
un troisième commutateur, dans lequel le troisième commutateur est commandé par un troisième signal d'horloge (CK180) pour coupler sélectivement le deuxième signal d'horloge (CK90) à un deuxième nœud ;
un quatrième commutateur, dans lequel le quatrième commutateur est commandé par le troisième signal d'horloge pour coupler sélectivement le deuxième nœud à la tension de masse ; et
un deuxième filtre, configuré pour filtrer les tensions au niveau du deuxième nœud afin de générer un deuxième résultat de détection.

5. Détecteur de phase en quadrature (110) selon la revendication 4, dans lequel idéalement la différence de phase entre le deuxième signal d'horloge (CK90) et le troisième signal d'horloge (CK180) est égale à 90 degrés, et le détecteur de phase en quadrature (110) comprend en outre :
un troisième circuit de détection (116, 116'), comprenant :
un cinquième commutateur, dans lequel le cinquième commutateur est commandé par un quatrième signal d'horloge (CK270) pour coupler sélectivement le troisième signal d'horloge (CK180) à un troisième nœud ;
un sixième commutateur, dans lequel le sixième commutateur est commandé par le quatrième signal d'horloge (CK270) pour coupler sélectivement le troisième nœud à la tension de masse ; et
un troisième filtre, configuré pour filtrer les tensions au niveau du troisième nœud afin de générer un troisième résultat de détection.

6. Détecteur de phase en quadrature (110) selon la revendication 1, dans lequel le détecteur de phase en quadrature (110) est intégré à un circuit (100), et le circuit comprend :
un générateur de signaux d'horloge (130), configuré pour générer un premier signal d'horloge (CK0) et un deuxième signal d'horloge (CK90),
un circuit de commande (120), couplé au premier circuit de détection (112, 112'), configuré pour générer un signal de commande afin d'ajuster une phase du premier signal d'horloge (CK0) ou du deuxième signal d'horloge (CK90) selon le premier résultat de détection.
